(19) Europäisches Patentamt
European Patent Office
Office européen des brevets

(11) **EP 4 313 604 B1**

(12) **EUROPÄISCHE PATENTSCHRIFT**

(45) Veröffentlichungstag und Bekanntmachung des Hinweises auf die Patenterteilung:
**30.04.2025 Patentblatt 2025/18**

(21) Anmeldenummer: **22718113.8**

(22) Anmeldetag: **23.03.2022**

(51) Internationale Patentklassifikation (IPC):
**B41J 2/21** (2006.01) **H10K 71/13** (2023.01)

(52) Gemeinsame Patentklassifikation (CPC):
**B41J 2/2132; H10K 71/135**

(86) Internationale Anmeldenummer:
**PCT/EP2022/057667**

(87) Internationale Veröffentlichungsnummer:
**WO 2022/200452 (29.09.2022 Gazette 2022/39)**

(54) **VERFAHREN ZUM BEDRUCKEN EINES SUBSTRATS MITTELS INKJET-DRUCK**

METHOD AND DEVICE FOR PRINTING ON A SUBSTRATE BY WAY OF INKJET PRINTING

PROCÉDÉ ET DISPOSITIF PERMETTANT D'IMPRIMER SUR UN SUBSTRAT AU MOYEN D'UNE IMPRESSION À JET D'ENCRE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **24.03.2021 DE 102021107415**

(43) Veröffentlichungstag der Anmeldung:
**07.02.2024 Patentblatt 2024/06**

(73) Patentinhaber: **Notion Systems GmbH**
**68723 Schwetzingen (DE)**

(72) Erfinder: **DORAN, Michael**
**69221 Dossenheim (DE)**

(74) Vertreter: **Dumlich, Heiko Alexander**
**Lab14 GmbH**
**C/o Specs Surface Nano Analysis GmbH**
**Voltastraße 5**
**13355 Berlin (DE)**

(56) Entgegenhaltungen:
**WO-A1-2013/145801 WO-A1-2018/099583**
**CN-A- 108 602 346**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft ein Verfahren zum Bedrucken eines Substrats mittels Inkjet-Druck.

Verfahren zum Bedrucken eines Substrats mittels Inkjet-Druck sind in vielfältiger Ausgestaltung aus dem Stand der Technik bekannt und werden für zahlreiche Anwendungen verwendet, beispielsweise zum Bedrucken sowohl starrer, als auch flexibler Substrate. Besonders geeignet ist das Verfahren zum Inkjet-Druck für spezifische Anwendungen, die es erfordern, eine genaue Menge einer funktionalen Flüssigkeit in mehrere, genau vorgegebene Oberflächenbereiche des Substrats, die jeweiligen Landezonen, zu platzieren. Solche Anwendungen betreffen beispielsweise technische oder medizinische Sensorflächen, Reaktionsflächen für Medizinanwendungen oder aber Pixelflächen von Displays, wie LCDs, TFTs, OLED-Displays oder E-Papier.

Aus WO 2018/099583 A1 ist ein Verfahren zum Bedrucken eines Substrats mit variierendem Muster von Landezonen mittels Ink-Jet Druck bekannt, das ein genaues Bedrucken eines gegenüber einem ideal orthogonalen Landepunktraster verschobenen, verdrehten oder verzerrten, insbesondere nicht linear verzerrten Landepunktrasters mit geringem Aufwand ermöglicht. Die Lateralauflösung wird so groß gewählt, dass der kleinste Abstand der Düsenlinien kleiner ist als der minimale Abstand zwischen den Landezonenreihen und dass bei einer durch das Substrat vorgegebenen Variation des Abstandes benachbarter Landezonenreihen zwischen verschiedenen Landezonenzeilen (Verzerrung) die Lage der Landezonen einer Landezonenzeile relativ zu den Düsenlinien ermittelt wird und daraus nur die Druckkopfdüsen, deren Düsenlinie eine Landezone schneiden, entsprechend einem Düsenansteuerschema und einem entsprechendem Landezonentyp angesteuert werden.

Aus WO 2013/145801 A1 ist ein Verfahren zum einfachen Festlegen eines bestimmten Tintenstrahlkopfdrehwinkels bekannt. Eine Bilderzeugungsvorrichtung enthält einen Tintenstrahlkopf, an dem eine Vielzahl an Ausstoßöffnungen gebildet ist, einen Rotationsmechanismus, um den Tintenstrahlkopf zu veranlassen, sich um eine Rotationsachse zu drehen, die sich in einer Richtung erstreckt, die ein Druckpapierblatt schneidet, einen Landepositions-Spezifikationsteil zum Spezifizieren der Landeposition von Tintentropfen, die aus zwei oder mehr Ausstoßöffnungen ausgegeben werden, die aus der Vielzahl von Ausstoßöffnungen ausgewählt sind, und ein Drehwinkel-Spezifikationsteil zum Spezifizieren des Tintenstrahlkopfdrehwinkels auf Basis des Abstandes entlang der senkrechten Richtung zwischen den durch das Landepositions-Spezifikationsteil spezifizierten Landepositionen. Die zwei oder mehr Ausstoßöffnungen sind Ausstoßöffnungen, die keine gegenseitig benachbarten Auftreffpositionen in Bezug auf die senkrechte Richtung haben, die senkrecht zur Bewegungsrichtung des Druckpapiers ist.

Aus CN 108 602 346 A ist ein Verfahren zum Erzeugen einer Schicht mit einer bestimmten Dicke mit einem Drucker, der eine Flüssigkeit aufträgt bekannt. Das Verfahren umfasst das automatische Einstellen von Druckparametern auf der Grundlage von speziell gemessenen oder geschätzten Tinten- oder Substrateigenschaften. In einer Ausführungsform werden die Ausbreitungseigenschaften der Tinte verwendet, um die Tropfengröße auszuwählen, die zur Herstellung einer bestimmten Schicht verwendet wird, und/oder um ein bestimmtes Ausgangsvolumen/eine bestimmte Ausgangsfläche oder eine bestimmte Tropfendichte auszuwählen, die dann skaliert und/oder angepasst wird, um die Homogenität der Schicht zu gewährleisten. In einer zweiten Ausführungsform werden die erwarteten Angaben pro Tropfen dazu verwendet, die Tropfen zu verschachteln, um das Verschmelzen der aufgebrachten Tropfen sorgfältig zu kontrollieren und so die Homogenität der Schicht zu unterstützen. Die flüssige Schicht wird dann ausgehärtet oder eingebrannt, um eine dauerhafte Struktur zu erhalten.

Insbesondere bei dem Druck von RGB-Mustern als Farbfilter auf E-Papier-Displays werden typischerweise zahlreiche Landezonen bedruckt, wobei die Größe eines jeden zu druckenden Einzelmusters sehr unterschiedlich und dabei sowohl sehr klein, beispielsweise 40 x 40 $\mu$m, aber auch groß, wie 200 x 1000 $\mu$m, sein kann. Eine typische Größe der Einzelmuster ist jedoch etwa 60 x 200 $\mu$m. Um mittels E-Papier eine farbige Darstellung zu ermöglichen, ist in den Regionen, in denen das unterliegende E-Papier weiß getrieben wird, eine gedruckte Farbschicht, insbesondere einzelne rote (R), grüne (G) und blaue (B) Pixelflächen als Filter, sichtbar. Dagegen absorbieren die E-Papier-Pixel, welche schwarz getrieben werden, das Licht, sodass nur noch sehr schwach der gedruckte RGB-Farbfilter sichtbar ist und somit die E-Papier-Pixel beinahe ohne Farbeindruck erscheinen. Üblicherweise bilden beim farbigen E-Papier jeweils drei farbige Subpixel (RGB) und ggf. zusätzlich ein weißer Subpixel einen Pixel eines hochauflösenden Pixelarrays. Dabei stellt jeder (farbige) Subpixel eine Landezone sowie jede Farbe einen eigenen Landezonentyp für das Bedrucken dar.

Um eine hohe Qualität des Druckergebnisses, insbesondere der Oberfläche eines E-Papiers, zu erreichen, ist es notwendig, dass über die gesamte Fläche des Substrats die einzelnen Subpixel gleichmäßig gebildet werden. Dabei ist sowohl die Positionierung und Größe der Pixel, als auch die in jedes Subpixel als Landezone des Drucks abgegebene Menge des Farbfilters innerhalb enger Grenzen von großer Bedeutung.

Um ein reproduzierbares und störungsfreies Druckergebnis erhalten zu können, ist es bei den Anwendungen des Inkjet-Drucks zur Dosierung im Stand der Technik üblich, dass in jeder Landezone eines Landezonentyps, d.h. in alle Landezonen gleicher Funktion, Farbe, Form und/oder Größe, die exakt gleiche Tintenmenge bzw. die exakt selbe Anzahl von Inkjet-Tropfen platziert werden.

Das Auge eines Betrachters ist dabei sehr empfindlich im Aufspüren von Intensitätsunterschieden im bedruckten Substrat, insbesondere bei Farbfiltern von E-Papier, insbesondere wenn mehrere gedruckte Einzelmuster neben- und/oder untereinander ähnliche fehlerhafte Eigenschaften aufweisen, die zugleich leicht unterschiedlich von den übrigen Einzelmustern einer benachbarten Region sind.

In der Praxis ergeben sich solche leichten Unterschiede häufig durch inhärente Drucckopfdüsenschwankungen, wobei der optische Eindruck eines Subpixels von übrigen Subpixeln deutlich abweicht, wenn die bedruckten Flächen unterschiedlich groß sind, obgleich die exakt gleiche Tintenmenge gedruckt wurde. Umgekehrt ist der Eindruck bei gleicher Fläche, aber geringfügig unterschiedlicher Tintenmenge ebenfalls deutlich unterschiedlich. Somit können Positionsschwankungen der Druckkopfdüsen, welche zu Flächenschwankungen führen, und/oder echte Volumenschwankungen der Tintenmenge zu solchen unerwünschten Effekten führen.

Auch ein unterschiedliches zeitliches Auftreffen der Tropfen eines Einzelmusters auf das Substrat kann zu einem voneinander abweichenden optischen Eindruck mehrerer Einzelmuster führen, da das Druckmedium auf dem Substrat gegebenenfalls nicht sofort absorbiert wird und Oberflächenspannungseffekte des gerade gedruckten Tropfens zu einem systematischen Fließen des Druckmediums hin zu bereits zuvor gedruckten Tropfen führen können.

Der Erfindung liegt daher die Aufgabe zugrunde, ein Verfahren zum Bedrucken eines Substrats mittels Inkjet-Druck bereitzustellen, das effizient und in einfacher Weise ein Bedrucken eines Substrats ermöglicht, wobei das Druckergebnis besonders gleichmäßig und störungsfrei ist und wobei insbesondere ein Auftreten optisch auffällig unterschiedlicher Zonen vermieden wird.

Die Aufgabe wird erfindungsgemäß durch ein Verfahren gemäß Anspruch 1 gelöst. Vorteilhafte Weiterbildungen der Erfindung sind in den abhängigen Ansprüchen angegeben.

Bei dem erfindungsgemäßen Verfahren zum Bedrucken eines Substrats mittels Inkjet-Druck sind auf dem Substrat Landezonen, insbesondere in einem Landezonenraster aus Landezonenzeilen und Landezonenreihen, vorgegeben, wobei die Landezonen jeweils mit einem Einzelmuster bestehend aus wenigstens zwei Tropfen mittels Druckkopfdüsen mindestens eines Druckkopfes bedruckt werden, wozu die Druckkopfdüsen und die Oberfläche des Substrats beim Bedrucken relativ zueinander, insbesondere entlang einer fiktiven Düsenbahn, bewegt werden. Dabei erfolgt das Drucken der Tropfen innerhalb wenigstens einem Teil der Einzelmuster, bevorzugt innerhalb jedem der Einzelmuster derart, dass einer gegenseitigen Beeinflussung der Tropfen innerhalb eines Einzelmusters auf dem Substrat entgegengewirkt wird.

Das erfindungsgemäße Verfahren erlaubt es in vorteilhafter Weise, ein besonders gleichmäßiges und störungsfreies Druckergebnis zu erzielen, da Einflüsse der einzelnen Tropfen eines Einzelmusters untereinander so gering wie möglich gehalten werden und entsprechend jeder Tropfen einzeln und in gleicher Weise zu dem optischen Gesamtergebnis beiträgt. Dies ist insbesondere für den Druck von Einzelmustern aus deutlich mehr als einem Tropfen auf der Oberfläche des Substrats von besonderer Relevanz, da es hier durch die benachbarte Anordnung immer wenigstens zwei identischer Tropfen leicht zu starken und häufigen Störungen des Druckbildes kommen kann.

Unter einem Bedrucken wird grundsätzlich ein Verfahren verstanden, bei dem ein flüssiges oder fließfähiges Druckmedium auf eine Oberfläche aufgebracht wird, wobei dies gezielt nach einer Vorlage, nach einem vorgegebenen Muster und/oder an einer vorgegebenen Position erfolgt. Erfindungsgemäß ist das Druckverfahren ein Inkjet-Druck, also ein Matrixdruck, bei dem das aufzubringende Druckmedium in Tropfen oder als Strahl auf das zu bedruckende Medium aufgebracht wird. Entsprechend erfolgt das Bedrucken bevorzugt kontaktlos, d.h. ohne eine direkte Berührung der Vorrichtung zum Bedrucken mit dem Substrat.

Das Bedrucken erfolgt mittels eines oder mehrerer Druckköpfe, wobei der Druckkopf beim Bedrucken relativ zu dem zu bedruckenden Substrat bewegt werden kann, sodass verschiedene Positionen des Substrats bedruckbar sind. Dabei kann sowohl der Druckkopf feststehend sein und das Substrat bewegt werden, als auch das Substrat feststehend sein und der Druckkopf bewegt werden. Grundsätzlich weist der Druckkopf wenigstens eine Druckkopfdüse zur Abgabe von Tropfen oder eines Strahls des Druckmediums auf, wobei bevorzugt zahlreiche Druckkopfdüsen am Druckkopf in einer Reihe und besonders bevorzugt dabei äquidistant zueinander angeordnet sind. Zudem können die Druckkopfdüsen auch in mehreren Reihen, insbesondere in einer Druckrichtung hintereinander und/oder lateral zueinander versetzt, am Druckkopf angeordnet sein. Ganz besonders bevorzugt sind die einzelnen Druckkopfdüsenreihen dabei derart lateral zueinander versetzt, dass alle Düsenbahnen des Druckkopfes zueinander den gleichen Abstand aufweisen, wodurch eine gleichmäßige Lateralauflösung erreicht wird.

Die unter dem Bereich der Druckkopfdüsen liegende Substratoberfläche während des Druckens und bevorzugt während einer einzelnen Überfahrt des Druckkopfes relativ zur Substratoberfläche wird als Druckerkopfbahn bezeichnet, während die senkrechte Projektion jeder einzelnen Druckkopfdüse auf die Oberfläche des Substrats einer bei dem Bedrucken vollzogenen Bewegungsbahn als Düsenbahn bezeichnet wird. Entsprechend wird die Düsenbahn nicht zwingend physisch auf dem Substrat abgebildet, sondern ist zunächst eine fiktive Verlaufsbahn. Würde jedoch eine Druckdüse während einer Linearbewegung über dem maximalen Druckbereich bzw. entlang einer Landezonenzeile durchgehend ein Druckmedium abgeben, so würde die Düsenbahn mittels des Druckmediums auf der Oberfläche des Substrats wiedergegeben. Dabei kann die Düsenbahn grundsätzlich sowohl linear verlaufen, als auch einen beliebigen anderen, nicht-linearen Verlauf aufweisen und/oder auch einen beliebigen Winkel zu den Landezonenzeilen oder den Landezonenreihen aufweisen. Besonders bevorzugt ist eine Ausführung des Verfahrens, die ausrichtungsfrei, d.h. ohne eine dem Druck vorausgehende Ausrichtung des Substrats relativ zur Druckdüsenbahn, insbesondere anhand von Ausrichtungsmerkmalen, erfolgt. Ein Druckkopf mit mehreren, in einer Reihe angeordneten Druckkopfdüsen erzeugt bei einer einzelnen Überfahrt des Substrats mehrere fiktive Düsenbahnen über der Substratoberfläche, wobei der Abstand zwischen den Düsenbahnen der nativen Lateralauflösung des Druckkopfes entspricht.

Das Druckmedium, das als Tropfen beim Bedrucken auf das Substrat aufgebracht wird, kann grundsätzlich eine beliebige Flüssigkeit sein und zu beliebigen Zwecken dienen. Das Druckmedium kann beispielsweise auf einem wässrigen oder nicht-wässrigen Lösungsmittel basieren und zudem beliebige weitere, funktionale Komponenten aufweisen, beispielsweise Farbstoffe und Pigmente, aber auch chemisch und/oder biochemisch aktive Substanzen. Besonders bevorzugt handelt es sich bei dem Druckmedium um eine Tinte bzw. eine Filterfarbstofflösung, um ein Subpixel eines Displays zu drucken.

Das Substrat kann grundsätzlich aus einem beliebigen Material gebildet sein und eine beliebige Form aufweisen, wobei das Substrat bevorzugt eine ebene, bedruckbare Oberfläche aufweist und besonders bevorzugt generell flach, insbesondere als Platte oder Folie, gebildet ist. Dabei kann das Substrat sowohl starr, als auch flexibel sein. Ein Beispiel eines flexiblen Substrats ist ein flexibles EPD (electronic paper display), das als unbedrucktes Substrat eine ursprüngliche schwarz-/weiß-Auflösung von 150 ppi mit jeweils 170 μm TFT-Pixelgröße aufweist. Um auf Basis eines solchen EPD eine Farbanzeige zu erzeugen, wird ein RGB-Filter oben auf jedes schwarz/weiß -TFT-Pixel gedruckt, wobei jedes Farbpixel gewöhnlich etwas kleiner ist als die TFT-Pixelgröße, z.B. lediglich 150 μm. Die resultierende Farbanzeigeauflösung liegt dann beispielsweise bei 75 ppi. Dabei werden bevorzugt mehrere, beispielsweise vier Landezonenraster verschoben zueinander auf der Oberfläche des Substrats angeordnet, wobei ein Raster mit rotem Farbfilter, ein Raster mit grünem Farbfilter, ein Raster mit blauem Farbfilter bedruckt wird und das vierte Raster unbedruckt bleibt. Weiterhin bevorzugt ist in jedem TFT-Pixel wenigstens eine Landezone eines Landezonentyps, beispielsweise einer Farbe, angeordnet.

Ein wichtiges Kriterium für eine hohe Qualität ist die präzise Platzierung von Farbpixeln in die vorgesehenen Positionen eines jeden TFT-Pixels, wobei diese Soll-Positionen typischerweise durch das Substrat, beispielsweise in Form von Vertiefungen im Substrat oder als TFT-Raster, als Landezonen vorgegeben werden. Während andere Kriterien ebenso gelten könnten, ist es zumeist eine essentielle Bedingung, dass das Farbpixel bzw. ein Subpixel innerhalb des TFT-Pixels nicht in benachbarte TFT-Pixel übergreifen darf, sondern für alle Pixel über eine aktive Matrixanzeige innerhalb des TFT-Pixelbereichs liegen muss.

Entsprechend handelt es sich bei einer Landezone um eine unterliegende Struktur innerhalb des Displays, z.B. ein TFT getriebener Pixel eines Displays, wobei die Landezonen bevorzugt vorgesehen sind, jeweils mit genau einem Einzelmuster bedruckt zu werden. Grundsätzlich können die Landezonen dabei physikalisch auf dem Substrat vorgegeben sein oder lediglich an der Gesamtfläche bestimmte, jedoch am Substrat selber nicht direkt sichtbare Positionen darstellen. Dabei kann ein Substrat einen oder mehrere unterschiedliche Typen von Landezonen aufweisen. Unterschiedliche Typen von Landezonen können beispielsweise mit unterschiedlichen Druckmedien zu bedrucken sein, eine abweichende Menge des Druckmediums aufnehmen oder unterschiedliche Geometrien aufweisen. Bevorzugt sind die Landezonentypen auf dem Substrat systematisch bzw. sich in wenigstens einer, bevorzugt in zwei Raumrichtungen periodisch wiederholend angeordnet bzw. bilden sich wiederholende, übergeordnete Muster. Besonders bevorzugt weist ein E-Papier bzw. ein EPD wenigstens drei Landezonentypen in den Farben rot, grün und blau auf. Zudem ist denkbar, dass für eine oder mehrere dieser Farben Landezonentypen unterschiedlicher Form und/oder Größe vorgesehen sind, sodass sich die Gesamtanzahl der auf dem Substrat zu bedruckenden Landezonentypen entsprechend erhöht. Somit können auf einer Substratoberfläche mehrere Landezonenraster zueinander versetzt angeordnet sein, wobei bevorzugt mehrere Landezonenraster jeweils im Zwischenraum des anderen Landezonenrasters angeordnet sind, insbesondere derart, dass sich die einzelnen Landezonen der verschiedenen Landezonenraster entlang der Substratoberfläche periodisch wiederholen. Ganz besonders bevorzugt sind mehrere Landezonenraster mit leicht zueinander versetztem Ursprung vorgesehen, wobei die Landezonenraster insbesondere bevorzugt identisch zueinander gebildet sind.

Die einzelnen Landezonen des Substrats sind bevorzugt in einem Landezonenraster aus Landezonenzeilen und Landezonenreihen angeordnet, wobei die Landezonenzeilen und die Landezonenreihen besonders bevorzugt in einem festen Winkel und/oder in einer gleichbleibenden Anordnung zueinander über die gesamte Substratoberfläche positioniert sind. Ganz besonders bevorzugt sind die Landezonenzeilen und die Landezonenreihen senkrecht zueinander und/oder in einer rechteckigen Matrix ausgerichtet. Obwohl bevorzugt ist, dass die einzelnen Landezonenzeilen und Landezonenreihen identisch zueinander gebildet sind, können diese auch in ihrer Größe und/oder Anordnung voneinander abweichen, bis hin zu einer zufälligen Platzierung der einzelnen Landezonen im Landezonenraster, das dann ein pseudo-zufälliges Raster ist. Zur Ausrichtung des Substrats relativ zur Druckvorrichtung bzw. zur Düsenansteuerung kann das Substrat zudem Ausrichtungsmerkmale aufweisen, die bevorzugt optisch oder anderweitig sensorisch erfassbar sind.

Bei einem Einzelmuster handelt es sich um eine einzelne gedruckte Fläche, wobei jedes Einzelmuster aus wenigstens zwei Druckmediumtropfen bzw. Tintentropfen gebildet wird, die mittels einer oder mehreren Druckkopfdüsen gedruckt werden. Bevorzugt wird jedes Einzelmuster in genau eine Landezone gedruckt bzw. jede Landezone enthält genau ein Einzelmuster. Besonders bevorzugt sind alle Einzelmuster für einen Landezonentyp identisch zueinander und dabei ganz besonders bevorzugt aus einer identischen Anordnung und/oder Anzahl an Tropfen des Druckmediums gedruckt.

Um optische Störungen und Auffälligkeiten im Druckergebnis zu vermeiden, sieht das erfindungsgemäße Verfahren vor, dass das Drucken der Tropfen innerhalb wenigstens einem Teil der Einzelmuster, bevorzugt innerhalb jedem der Einzelmuster derart erfolgt, dass einer gegenseitigen Beeinflussung der Tropfen innerhalb eines Einzelmusters auf dem Substrat entgegengewirkt wird. Unter einer gegenseitigen Beeinflussung der Tropfen wird generell verstanden, dass das Verhalten eines auf dem Substrat auftreffenden Tropfens durch einen zuvor platzierten und/oder zugleich auftreffenden Tropfen gegenüber dem Verhalten eines isoliert auftreffenden Tropfens wenigstens derart verändert wird, dass sich der optische Eindruck des Druckergebnisses verändert.

Ein Beispiel einer solchen Beeinflussung ist das Zusammenlaufen von zwei Tropfen auf dem Substrat, wodurch typischerweise die Größe der bedeckten Fläche verringert und deren Intensität zugleich erhöht wird. Auch kann eine Beeinflussung dadurch entstehen, dass ein zu bedruckender Bereich des Substrats durch einen zuvor in einem benachbarten Bereich aufgetroffenen Tropfen bereits mit einem Teil des aufgetroffenen Tropfens oder einem Bestandteil des aufgetroffenen Tropfens, wie dessen Lösemittel, benetzt wird. Ein Vermeiden einer gegenseitigen Beeinflussung schließt jedoch nicht grundsätzlich aus, dass sich die Tropfen auf dem Substrat berühren dürfen, sondern eine berührungslose bzw. voneinander beabstandete Platzierung der Tropfen ist nur eine mögliche Ausführung. Vielmehr kann ein Vermeiden einer gegenseitigen Beeinflussung auch dadurch erfolgen, dass die Wechselwirkung der Tropfen untereinander symmetrisch ist, d.h., dass alle Tropfen eines Einzelmusters sich gegenseitig in gleichem Maße beeinflussen und dabei beispielsweise die Tropfen zueinander in gleichem Abstand und/oder zugleich auf das Substrat gedruckt werden.

Eine gegenseitige Beeinflussung kann dabei insbesondere durch eine räumliche und/oder die zeitliche Ansteuerung mindestens eines Druckkopfes und dabei insbesondere der einzelnen Druckkopfdüsen zum Drucken der Tropfen innerhalb wenigstens einem Teil der Einzelmuster, bevorzugt innerhalb jedem der Einzelmuster vermindert oder sogar verhindert werden, wobei diese Ansteuerung besonders bevorzugt derart erfolgt, dass eine Tropfenplatzierung innerhalb eines Einzelmusters auf dem Substrat mit möglichst geringen Wechselwirkungen und insbesondere eine wechselwirkungsfreie Tropfenplatzierung erreicht wird. Im Rahmen einer solchen räumlichen und/oder zeitlichen Ansteuerung kann insbesondere die Reihenfolge, die zeitliche Abfolge und/oder die räumliche Position der Tropfenplatzierung variiert bzw. angepasst werden.

Um zugleich einen besonders schnellen Druck sowie eine besonders genaue Positionierung der Tropfen zu erreichen, sieht eine bevorzugte Ausgestaltung des erfindungsgemäßen Verfahrens zum Bedrucken eines Substrats vor, dass der Druck aller Tropfen eines Einzelmusters und/oder aller Tropfen des Bereichs unterhalb des Druckkopfes während genau einer Relativbewegung des Druckkopfes und des Substrats, insbesondere in genau einer Überfahrt, erfolgt.

Bei einer vorteilhaften Weiterbildung des erfindungsgemäßen Verfahrens zum Bedrucken eines Substrats erfolgt der Druck aller Tropfen eines Einzelmusters innerhalb eines Zeitintervalls von weniger als 100 ms, bevorzugt von weniger als 50 ms, besonders bevorzugt von weniger als 10 ms und ganz besonders bevorzugt von weniger als 1 ms, wodurch in besonders einfacher Weise eine gegenseitige Beeinflussung durch ein Verlaufen eines Tropfens in den Bereich eines nachfolgend auftreffenden Tropfens auf dem Substrat verhindert wird. Dadurch, dass alle Tropfen nahezu zugleich auf dem Substrat auftreffen, ist der Zustand des Substrats für alle Tropfen identisch und zudem erfolgt die Wechselwirkung zweier benachbart in einem Einzelmuster gedruckter Tropfen, soweit solch eine Wechselwirkung auftritt, bei jedem der Tropfen durch den jeweiligen anderen Tropfen in gleichem Maße, sodass beide Tropfen letztendlich zu einem identischen optischen Eindruck des bedruckten Substrats führen. Weiterhin ist bevorzugt, dass der Druck aus allen nebeneinanderliegenden Druckkopfdüsen in eine einzige Landezone zugleich erfolgt und/oder der Druck aller Tropfen eines Einzelmusters in der Bewegungsrichtung des Druckkopfes relativ zum Substrat hintereinander und/oder in dieser Reihenfolge erfolgt.

Eine besonders bevorzugte Ausgestaltung des erfindungsgemäßen Verfahrens sieht vor, dass alle Tropfen eines Einzelmusters derart auf dem Substrat platziert werden, dass die Tinte der einzelnen Tropfen nicht mit der Tinte aller anderen Tropfen, insbesondere des jeweiligen Einzelmusters, auf dem Substrat in Berührung kommt, um ein Verschmelzen von mehreren Tropfen zu verhindern. Dabei wird das Volumen eines Tropfens und/oder der Abstand benachbart gedruckter Tropfen bevorzugt derart gewählt, dass der Abstand der Tropfen auf dem Substrat so klein wie möglich ist, sodass eine gute Farbabdeckung erreicht wird. Bei einer solchen nicht-berührenden Platzierung kann dann der Tropfenauftrag in einer beliebigen Reihenfolge und/oder in einer beliebigen zeitlichen Abfolge erfolgen.

Um besonders wirkungsvoll einer gegenseitigen Beeinflussung der Tropfen entgegenzuwirken, sieht eine bevorzugte Ausgestaltung des erfindungsgemäßen Verfahrens vor, dass alle Tropfen aller Einzelmuster eines einzigen Landezonentyps unterhalb des Druckkopfes in einer einzigen Überfahrt gedruckt werden und/oder während genau einer Relativbewegung des Druckkopfes und des Substrats, insbesondere in genau einer Überfahrt, ausschließlich Einzelmuster eines einzigen Landezonentyps mit dem einen Druckkopf bzw. mit einem einzigen von mehreren Druckköpfen gedruckt werden, wobei bevorzugt zugleich jedes der Einzelmuster vollständig bzw. alle Tropfen des jeweiligen Einzelmusters gedruckt werden. Ganz besonders bevorzugt ist, dass nur eine Überfahrt pro Landezonentyp erfolgt bzw. ausschließlich alle Einzelmuster eines spezifischen Landezonentyps während genau einer Überfahrt gedruckt werden. Weiterhin ist bevorzugt, dass keine Tropfen in Einzelmuster eines anderen Landezonentyps unterhalb des Druckkopfes während einer spezifischen Überfahrt gedruckt werden.

Zur Erhöhung der Positionsauflösung über die native Positionsauflösung des Druckkopfes hinaus erfolgt der Druck jedes Einzelmusters und/oder jeder Bewegungsbahn des Druckkopfes relativ zum Substrat bevorzugt in $k$ Interlacingüberfahrten, wobei jeweils der Druckkopf und die Oberfläche des Substrats relativ zueinander um eine laterale Interlacingdistanz $x = j \times \frac{a}{k}$ versetzt werden, wobei $a$ der kleinste Abstand zwischen zwei Düsenbahnen, insbesondere der nativen Druckauflösung, bzw. der Abstand $a$ zweier benachbarter Druckkopfdüsen des Druckkopfes ist. Besonders bevorzugt wird zudem j<$k$ gewählt. Dabei ist $j$ bevorzugt gewählt aus der Menge aller natürlicher Zahlen einschließlich Null. Die Ganzzahl $j$ kann von Überfahrt zu Überfahrt variieren oder aber für mehrere Überfahrten oder den gesamten Druck gleich sein. Somit wird die Anzahl der Interlaces $k$ zur Erhöhung der Druckauflösung verwendet, sodass mit einer nativen Druckauflösung von 600 ppi sowie einem $k = 4$ eine effektive Druckauflösung von 2400 ppi auf dem Substrat erreicht werden kann.

Um darüber hinaus eine unerwünschte bzw. asymmetrische Wechselwirkung der Tropfen eines Einzelmusters zu minimieren oder sogar ganz auszuschließen, erfolgt bei einer vorteilhaften Weiterbildung des erfindungsgemäßen Verfahrens der Druck aller Tropfen in jedes Einzelmuster bei einer Interlacingüberfahrt in weniger als 100 ms, bevorzugt in weniger als 50 ms, besonders bevorzugt in weniger als 10 ms und ganz besonders bevorzugt in weniger als 1 ms.

Obwohl das Substrat grundsätzlich eine beliebige Oberfläche sein kann, ist das Substrat bevorzugt eine Displayoberfläche und insbesondere bevorzugt die Oberfläche eines E-Papiers, sodass eine entsprechende Weiterbildung des erfindungsgemäßen Verfahrens zur Herstellung von farbigem E-Papier vorgesehen ist. Dabei besteht die besondere Herausforderung gegenüber einem herkömmlichen Inkjet-Druck, beispielsweise dem Druck einer Graphik auf ein Papier, darin, dass ein periodisches Muster aus sich wiederholenden Farbpixeln gedruckt werden soll, auf dem lokale optische Fehler und Unregelmäßigkeiten besonders leicht auffallen, sodass ein besonders exaktes und störungsfreies Druckergebnis über die gesamte bedruckte Fläche notwendig ist. Entsprechend ist es auch besonders bevorzugt, dass die Einzelmuster und/oder die Einzelmustertypen Filterflächen eines Displays, insbesondere eines E-Papiers, sind.

Mehrere Ausführungsbeispiele des erfindungsgemäßen Verfahrens werden nachstehend näher erläutert:

Ein flexibles E-Papier-Display als ein Beispiel für ein flexibles Substrat mit einer schwarz/weiß-Auflösung von 150 ppi mit jeweils 170 μm TFT-Pixelgröße soll beispielhaft mit einer einzelnen Filterfarbe bedruckt werden. Dabei soll jedes Farbpixel etwas kleiner sein als die TFT-Pixelgröße, d.h. in etwa 150 μm. Entsprechend sind auf dem Substrat Landezonen zur Aufnahme der Filterfarbe in einem rechteckigen Raster aus Landezonenzeilen und Landezonenreihen vorgesehen. Die Landezonenzeilen verlaufen dabei in etwa in einer Druckrichtung, in der das Substrat unterhalb eines Druckkopfes mit sechzehn in einer Reihe angeordneten Druckkopfdüsen gefahren werden kann, um das Substrat bedrucken zu können. Dabei muss jedoch grundsätzlich keine präzise parallele Ausrichtung der Landezonenzeilen zu der Druckrichtung vorliegen.

In der Praxis und im Gegensatz zu diesem stark vereinfachten Beispiel wird typischerweise nicht ein einzelnes Landezonenraster, sondern mehrere zueinander verschobene Landezonenraster gedruckt, wobei die einzelnen Landezonen eines Landezonentyps auf dem Substrat sich wiederholend angeordnet sind. Typischerweise wird dabei wenigstens jeweils eine Landezone eines Landezonentyps, beispielsweise einer Farbfilterfläche, in einen Farbpixel gedruckt.

Aus technischen Gründen ist es jedoch dabei nicht immer möglich, die zu bedruckende Substratfläche so herzustellen, dass auf die Substratfläche treffende Tropfen sofort vollständig am Ort des Auftreffens vom Substrat absorbiert werden. Insbesondere kann es vorkommen, dass Tropfen innerhalb eines Einzelmusters so angeordnet werden, dass sich die gedruckten Tropfen auf dem Substrat berühren. In diesem Fall könnten Oberflächenspannungseffekte der noch "nassen" Tinte und des Substrats dazu führen, dass mehrere Tropfen eines Einzelmusters verschmelzen. Die genaue daraus resultierende Geometrie der verschmolzenen Tropfen wird dabei jedoch maßgeblich durch die räumliche und die zeitliche Abfolge der aufgebrachten Tropfen beeinflusst.

Daraus ergeben sich verschiedene Möglichkeiten, ein Substrat für ein E-Papier mittels Inkjet-Druck gemäß einer Ausführung des erfindungsgemäßen Verfahrens zu bedrucken, wobei die Landezonen auf dem flexiblen Substrat des E-Papiers jeweils mit einem Einzelmuster bestehend aus wenigstens zwei Tropfen mittels der Druckkopfdüsen mindestens eines Druckkopfes bedruckt werden. Grundsätzlich wird das Verfahren so betrieben und insbesondere dazu der wenigstens eine Druckkopf derart gesteuert, dass das Drucken der Tropfen innerhalb jedem einzelnen Einzelmuster mit einer kleinstmöglichen gegenseitigen Beeinflussung der Tropfen innerhalb jedes Einzelmusters auf dem Substrat erfolgt.

Eine bevorzugte Ausführung des Verfahrens mit einer kleinstmöglichen gegenseitigen Beeinflussung der Tropfen sieht dabei zunächst eine Auswahl einer Anzahl einzelner Einzelmuster vor, die dann jeweils vollständig in einer einzigen Überfahrt des Druckkopfes bzw. während einer einzelnen Relativbewegung des Druckkopfes zum Substrat gedruckt werden. Dabei erfolgt der Druck aller Tropfen eines Einzelmusters innerhalb von höchstens 2 ms.

Bei einer speziellen Ausführung des Verfahrens mit einer kleinstmöglichen gegenseitigen Beeinflussung der Tropfen erfolgt der Druck aller Tropfen jedes Einzelmusters bzw. jedes Einzelmusters eines spezifischen Einzelmustertyps, beispielsweise der roten Pixel, während genau einer Relativbewegung des Druckkopfes relativ zum Substrat, wodurch einerseits alle Tropfen eines Einzelmusters in sehr schneller zeitlicher Abfolge und andererseits in einer festgelegten, sich für alle Einzelmuster wiederholenden Reihenfolge erfolgt.

Weiterhin werden die Tropfen eines Einzelmusters bevorzugt derart platziert, dass diese wenigstens im Moment des Auftreffens auf eine Oberfläche des Substrats nicht unmittelbar mit einem anderen Tropfen in Berührung kommen. Insbesondere ist es bevorzugt, die Tropfen derart zu platzieren, dass diese gar nicht miteinander oder erst sehr spät, kurz vor dem vollständigen Trocknen, auf dem Substrat miteinander in Berührung kommen.

Weitestgehend gleichförmige gedruckte Einzelmuster, insbesondere eines gleichen Landezonentyps, beispielsweise einer jeweiligen Filterfläche einer Farbe, wird man im Rahmen einer möglichen Ausgestaltung des Verfahrens zum Druck mit einer kleinstmöglichen gegenseitigen Beeinflussung der Tropfen dann überall auf dem Substrat erreichen, wenn alle Tropfen aller gedruckten Einzelmuster während der gleichen Fahrt bzw. Relativbewegung vollständig gedruckt werden. Dazu ist es vorteilhaft, dass der Abstand der Druckkopfdüsen dem gewünschten Abstand der Tropfen auf der Substratoberfläche, d.h., der gewünschten Druckauflösung in Lateralrichtung, entspricht. Alternativ ist es auch denkbar, dass ein Druckkopf mit mehreren hintereinander angeordneten und lateral zueinander verschobenen Druckkopfdüsenreihen verwendet wird, um eine höhere Druckauflösung als die native Auflösung einer einzelnen Druckkopfdüsenreihe zu erreichen.

Alternativ oder zusätzlich kann die Lateralauflösung des Druckkopfes dadurch erhöht werden, dass der Druckkopf nach einer ersten Relativbewegung über eine Landezone in Lateralrichtung verfahren wird und im Rahmen einer weiteren Relativbewegung ein weiterer Druck von Tropfen in die Zwischenräume zwischen bereits gedruckte Tropfen erfolgt. Um jedoch auch dabei eine unerwünschte Wechselwirkung zwischen den Tropfen zu verhindern, werden alle Tropfen, die bei der ersten Relativbewegung des Druckkopfes zum Substrat abgesetzt werden im Einzelmuster nahezu gleichzeitig (typisch < 1 - 2 ms) abgesetzt, während die nächste Relativbewegung und entsprechend der nächste Tropfenauftrag in dieses Einzelmuster typischerweise ungefähr nach 0,5 s bis 2 s durchgeführt wird.

Beispielsweise könnte ein E-Paper Display aus 84,5 Mikrometer großen quadratischen Schwarz/Weiß-Pixeln bestehen und es könnte gewünscht sein, dass mit roter, grüner und blauer Farbfiltertinten gedruckt wird. Im einfachsten Fall benötigt man daher drei Landezonentypen, nämlich eine für rote, eine für blaue und eine für grüne Pixel. Zur Erhöhung der Platzierungsgenauigkeit kann es gewünscht sein, dass die Substratfläche mit $n$=3 Fahrten, d.h. Relativbewegungen, überstrichen wird, sodass die native Auflösung des Druckkopfs von beispielsweise 1200 dpi auf 3 x 1200 = 3600 dpi erhöht wird.

**Patentansprüche**

1. Verfahren zum Bedrucken eines Substrats mittels Inkjet-Druck, bei dem

   - auf dem Substrat Landezonen vorgegeben sind und
   - die Landezonen jeweils mit einem Einzelmuster bestehend aus wenigstens zwei Tropfen mittels Druckkopfdüsen mindestens eines Druckkopfes bedruckt werden, wobei
   - die Druckkopfdüsen und die Oberfläche des Substrats beim Bedrucken relativ zueinander bewegt werden,

   **dadurch gekennzeichnet, dass**

   - das Drucken der Tropfen innerhalb wenigstens einem Teil der Einzelmuster, bevorzugt innerhalb jedem der Einzelmuster derart erfolgt, dass einer gegenseitigen Beeinflussung der Tropfen innerhalb eines Einzelmusters auf dem Substrat entgegengewirkt wird.

2. Verfahren zum Bedrucken eines Substrats nach Anspruch 1, **dadurch gekennzeichnet, dass** die räumliche und/oder die zeitliche Ansteuerung des mindestens einen Druckkopfes zum Drucken der Tropfen innerhalb wenigstens einem Teil der Einzelmuster, bevorzugt innerhalb jedem der Einzelmuster derart erfolgt, dass eine wechselwirkungsfreie Tropfenplatzierung innerhalb eines Einzelmusters auf dem Substrat erreicht wird.

3. Verfahren zum Bedrucken eines Substrats nach Anspruch 1 oder 2, **dadurch gekennzeichnet, dass** der Druck aller Tropfen eines Einzelmusters und/oder aller Tropfen des Bereichs unterhalb des Druckkopfes während genau einer Relativbewegung des Druckkopfes und des Substrats, insbesondere in genau einer Überfahrt, erfolgt.

4. Verfahren zum Bedrucken eines Substrats nach wenigstens einem der vorhergehenden Ansprüche, **dadurch gekennzeichnet, dass** der Druck aller Tropfen eines Einzelmusters innerhalb eines Zeitintervalls von weniger als 100 ms, bevorzugt von weniger als 50 ms, besonders bevorzugt von weniger als 10 ms und ganz besonders bevorzugt von weniger als 1 ms erfolgt.

5. Verfahren zum Bedrucken eines Substrats nach wenigstens einem der vorhergehenden Ansprüche, **dadurch gekennzeichnet, dass** alle Tropfen eines Einzelmusters derart auf dem Substrat platziert werden, dass die Tinte der einzelnen Tropfen nicht mit der Tinte aller anderen Tropfen, insbesondere des jeweiligen Einzelmusters, auf dem Substrat in Berührung kommt, um ein Verschmelzen von mehreren Tropfen zu verhindern.

6. Verfahren zum Bedrucken eines Substrats nach wenigstens einem der vorhergehenden Ansprüche, **dadurch gekennzeichnet, dass**

   - alle Tropfen aller Einzelmuster eines einzigen Landezonentyps unterhalb des Druckkopfes in einer einzigen Überfahrt gedruckt werden und/oder
   - während genau einer Relativbewegung des Druckkopfes und des Substrats, insbesondere in genau einer Überfahrt, ausschließlich Einzelmuster eines einzigen Landezonentyps mit dem einen Druckkopf bzw. mit einem einzigen von mehreren Druckköpfen gedruckt werden, wobei
   - bevorzugt zugleich jedes der Einzelmuster vollständig bzw. alle Tropfen des jeweiligen Einzelmusters gedruckt werden.

7. Verfahren zum Bedrucken eines Substrats nach wenigstens einem der vorhergehenden Ansprüche, **dadurch gekennzeichnet, dass** zur Erhöhung der Positionsauflösung über die native Positionsauflösung des Druckkopfes hinaus der Druck jedes Einzelmusters und/oder jeder Bewegungsbahn des Druckkopfes relativ zum Substrat in $k$ Interlacingüberfahrten erfolgt, wobei der Druckkopf und die Oberfläche des Substrats bei jeder der Überfahrten relativ zueinander um eine laterale Interlacingdistanz $x = j \times \frac{a}{k}$ versetzt werden, wobei $a$ der kleinste Abstand zwischen zwei Düsenbahnen ist und bevorzugt $j < k$ ist.

8. Verfahren zum Bedrucken eines Substrats nach wenigstens einem der vorhergehenden Ansprüche, **dadurch gekennzeichnet, dass** der Druck aller Tropfen in jedes Einzelmuster bei einer Interlacingüberfahrt in weniger als 100 ms, bevorzugt in weniger als 50 ms, besonders bevorzugt in weniger als 10 ms und ganz besonders bevorzugt in weniger als 1 ms erfolgt.

9. Verfahren zum Bedrucken eines Substrats nach wenigstens einem der vorhergehenden Ansprüche, **dadurch gekennzeichnet, dass** das Substrat eine Displayoberfläche und insbesondere die Oberfläche eines E-Papiers ist.

10. Verfahren zum Bedrucken eines Substrats nach wenigstens einem der vorhergehenden Ansprüche, **dadurch gekennzeichnet, dass** die Einzelmuster und/oder die Einzelmustertypen Filterflächen eines Displays, insbesondere eines E-Papiers, sind.

## Claims

1. A method for printing on a substrate by means of inkjet printing, in which method

   - landing zones are specified on the substrate and
   - the landing zones are each printed with an individual pattern consisting of at least two droplets by means of print head nozzles of at least one print head, wherein
   - the print head nozzles and the surface of the substrate are moved relative to one another during printing,

   **characterized in that**

   - the printing of the droplets within at least a part of the individual patterns, preferably within each of the individual patterns, is performed such that mutual influence of the droplets within an individual pattern on the substrate is counteracted.

2. The method for printing on a substrate according to claim 1, **characterized in that** the spatial and/or the temporal control of the at least one print head for printing the droplets within at least a part of the individual pattern, preferably within each of the individual patterns, is performed such that an interaction-free drop placement within an individual pattern on the substrate is achieved.

3. The method for printing on a substrate according to claim 1 or 2, **characterized in that** the printing of all droplets of an individual pattern and/or of all droplets of the area below the print head is performed during exactly one relative movement of the print head and the substrate, in particular in exactly one pass.

4. The method for printing on a substrate according to at least one of the preceding claims, **characterized in that** the printing of all droplets of an individual pattern is performed within a time interval of less than 100 ms, preferably of less than 50 ms, more preferably of less than 10 ms, and most preferably of less than 1 ms.

5. The method for printing on a substrate according to at least one of the preceding claims, **characterized in that** all droplets of an individual pattern are placed on the substrate in such a way that the ink of the individual droplets does not come into contact with the ink of all other droplets, in particular of the respective individual pattern, on the substrate, in order to prevent the multiple droplets from coalescing.

6. The method for printing on a substrate according to at least one of the preceding claims, **characterized in that**

   - all droplets of all individual patterns of a single landing zone type are printed below the print head in a single pass and/or
   - during exactly one relative movement of the print head and the substrate, in particular in exactly one pass, exclusively individual patterns of a single landing zone type are printed using the one print head or using a single one of a plurality of print heads, wherein
   - preferably, each of the individual patterns is printed completely or all droplets of the respective individual pattern are printed at the same time.

7. The method for printing on a substrate according to at least one of the preceding claims, **characterized in that**, in order to increase the positional resolution beyond the native positional resolution of the print head, the printing of each individual pattern and/or each trajectory of the print head relative to the substrate is performed in $k$ interlacing passes, wherein the print head and the surface of the substrate are offset relative to one another by a lateral interlacing distance $x = j \times \frac{a}{k}$ during each of the passes, wherein $a$ is the smallest distance between two nozzle paths and is preferably $j < k$.

8. The method for printing on a substrate according to at least one of the preceding claims, **characterized in that** the printing of all droplets in each individual pattern during an interlacing pass is performed in less than 100 ms, preferably in less than 50 ms, more preferably in less than 10 ms, and most preferably in less than 1 ms.

9. The method for printing on a substrate according to at least one of the preceding claims, **characterized in that** the substrate is a display surface and in particular the surface of an e-paper.

10. The method for printing on a substrate according to at least one of the preceding claims, **characterized in that** the individual patterns and/or the individual pattern types are filter surfaces of a display, in particular an e-paper.

**Revendications**

1. Procédé pour l'impression sur un substrat au moyen d'une impression par jet d'encre, dans lequel

   - des zones d'atterrissage sont prédéfinies sur le substrat et
   - les zones d'atterrissage sont respectivement imprimées avec un motif individuel constitué d'au moins deux gouttes au moyen de buses de tête d'impression d'au moins une tête d'impression, dans lequel
   - les buses de tête d'impression et la surface du substrat se déplacent l'une par rapport à l'autre lors de l'impression,

   **caractérisé en ce que**

   - l'impression des gouttes à l'intérieur d'au moins une partie des motifs individuels, de préférence à l'intérieur de chacun des motifs individuels, est effectuée de telle sorte qu'une influence mutuelle des gouttes à l'intérieur d'un motif individuel sur le substrat est contrecarrée.

2. Procédé pour l'impression sur un substrat selon la revendication 1, **caractérisé en ce que** la commande spatiale et/ou temporelle de l'au moins une tête d'impression pour l'impression des gouttes à l'intérieur d'au moins une partie des motifs individuels, de préférence à l'intérieur de chacun des motifs individuels, est effectuée de telle sorte qu'un placement de gouttes sans interaction à l'intérieur d'un motif individuel sur le substrat est obtenu.

3. Procédé pour l'impression sur un substrat selon la revendication 1 ou 2, **caractérisé en ce que** l'impression de toutes les gouttes d'un motif individuel et/ou de toutes les gouttes de la zone en dessous de la tête d'impression est effectuée pendant exactement un mouvement relatif de la tête d'impression et du substrat, en particulier en exactement un passage.

4. Procédé pour l'impression sur un substrat selon au moins l'une des revendications précédentes, **caractérisé en ce que** l'impression de toutes les gouttes d'un motif individuel est effectuée dans un intervalle de temps inférieur à 100 ms, de préférence inférieur à 50 ms, de manière particulièrement préférée inférieur à 10 ms et de manière tout particulièrement préférée inférieur à 1 ms.

5. Procédé pour l'impression sur un substrat selon au moins l'une des revendications précédentes, **caractérisé en ce que** toutes les gouttes d'un motif individuel sont placées sur le substrat de telle sorte que l'encre des gouttes individuelles n'entre pas en contact avec l'encre de toutes les autres gouttes, en particulier du motif individuel respectif, sur le substrat, afin d'empêcher une fusion de plusieurs gouttes.

6. Procédé pour l'impression sur un substrat selon au moins l'une des revendications précédentes, **caractérisé en ce que**

- toutes les gouttes de tous les motifs individuels d'un seul type de zone d'atterrissage sont imprimées en dessous de la tête d'impression en un seul passage et/ou
- pendant exactement un mouvement relatif de la tête d'impression et du substrat, en particulier en exactement un passage, exclusivement des motifs individuels d'un seul type de zone d'atterrissage sont imprimés avec la tête d'impression ou avec une seule tête d'impression parmi plusieurs têtes d'impression, dans lequel
- de préférence, chacun des motifs individuels dans sa totalité ou toutes les gouttes du motif individuel respectif sont imprimés simultanément.

7. Procédé pour l'impression sur un substrat selon au moins l'une des revendications précédentes, **caractérisé en ce que,** pour augmenter la résolution de position au-delà de la résolution de position d'origine de la tête d'impression, l'impression de chaque motif individuel et/ou de chaque trajectoire de déplacement de la tête d'impression par rapport au substrat est effectuée en $k$ passages d'entrelacement, dans lequel la tête d'impression et la surface du substrat sont décalées l'une par rapport à l'autre d'une distance d'entrelacement latérale $x = j \times \frac{a}{k}$ lors de chacun des passages, dans lequel $a$ est la plus petite distance entre deux trajectoires de buse et de préférence $j < k$.

8. Procédé pour l'impression sur un substrat selon au moins l'une des revendications précédentes, **caractérisé en ce que** l'impression de toutes les gouttes dans chaque motif individuel lors d'un passage d'entrelacement est effectuée en moins de 100 ms, de préférence en moins de 50 ms, de manière particulièrement préférée en moins de 10 ms et de manière tout particulièrement préférée en moins de 1 ms.

9. Procédé pour l'impression sur un substrat selon au moins l'une des revendications précédentes, **caractérisé en ce que** le substrat est une surface d'affichage et en particulier la surface d'un papier électronique.

10. Procédé pour l'impression sur un substrat selon au moins l'une des revendications précédentes, **caractérisé en ce que** les motifs individuels et/ou les types de motifs individuels sont des surfaces de filtrage d'un écran, en particulier d'un papier électronique.

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2018099583 A1
- WO 2013145801 A1
- CN 108602346 A